# EUROPEAN PATENT APPLICATION

(11) **EP 2 015 347 A2**
(43) Date of publication of application: **14.01.2009**
(21) Application number: 08159862.5
(22) Date of filing: 07.07.2008
(51) Int. Cl.: H01L 21/00

(54) **Automated preform attach for vacuum packaging**

(30) Priority: 11.07.2007 US 776486
(71) Applicant: Honeywell International Inc., Morristown NJ 07960 (US)
(72) Inventor: Seppala, Bryan R., Mahtomedi, MN 55115 (US); DCamp, Jon B., Savage, MN 55378 (US); Curtis, Harlan L., Champlin, MN 55316 (US); Schaefer, David W., Champlin, MN 55316 (US); Deering, Gary L., Maple Grove, MN 55369 (US)
(74) Representative: Buckley, Guy Julian

(57) **Abstract**

Systems and methods for automatically attaching preforms to substrates. An example system includes a nest, a first component that places a substrate into the nest, a second component that places a preform on the substrate in the nest, a tacking device that tacks the preform to the substrate, a plurality of sensors that sense operational states of the components and the tacking device, and a controller that automatically controls operations of the components and the tacking device based on the sensed operational states.

## Description

### BACKGROUND OF THE INVENTION

Presently Leadless Chip Carriers (LCC's) are loaded into aluminum trays that hold 24 parts each. A preform is manually placed and positioned on the seal ring. The tray is placed on a heated stage 200-350°C and the preforms are repositioned. The stage is moved below a heated soldering iron tip 250-350°C and the tip is positioned above the preform. An operator uses a foot pedal to bring the tip in contact with the preform providing 1-2 pounds of force to tack the preform in place. Currently somewhere between 12 to 24 tacks are made on each preform. It is important to be sure that the preform is both secure and flat and has minimal stress. Any gaps between the preform and seal ring can lead to areas of non-wetting of the seal ring during vacuum seal which can cause vacuum leaks or voids. This process takes a considerable amount of time and does not guarantee product quality.

Therefore, there exists a need for improved processes and systems for increasing the accuracy of preform attachment and decreasing the manufacturing time, thus costs.

### SUMMARY OF THE INVENTION

The present invention provides systems and methods for automatically attaching preforms to substrates. An example system includes a nest, a first component that places a substrate into the nest, a second component that places a preform on the substrate in the nest and also aligns the preform while not necessarily securing the preform, a tacking device that tacks the preform to the substrate, a plurality of sensors that sense operational states of the components and the tacking device, and a controller that automatically controls operations of the components and the tacking device based on the sensed operational states.

In one aspect of the invention, the first component includes a conveyor component that transports substrates and a mechanical arm that retrieves one of the one or more substrates from the conveyor component and places the retrieved substrate in the nest.

In another aspect of the invention, the conveyor component includes a heating device that heats some of the substrates prior to retrieval by the mechanical arm.

In still another aspect of the invention, the mechanical arm returns the substrate with tacked preform back to the conveyor component.

In yet another aspect of the invention, the nest includes a heating device configured to heat the nested substrate.

### BRIEF DESCRIPTION OF THE DRAWINGS

Preferred and alternative embodiments of the present invention are described in detail below with reference to the following drawings:

FIGURE 1 is a block diagram of an automated system for attaching preforms to substrates;

FIGURES 2-5, 7 are perspective views of an example system formed in accordance with an embodiment of the present invention; and

FIGURE 6 illustrates an cross-sectional view of a solder tip formed in accordance with an embodiment of the present invention.

### DETAILED DESCRIPTION OF THE PREFERRED EMBODIMENT

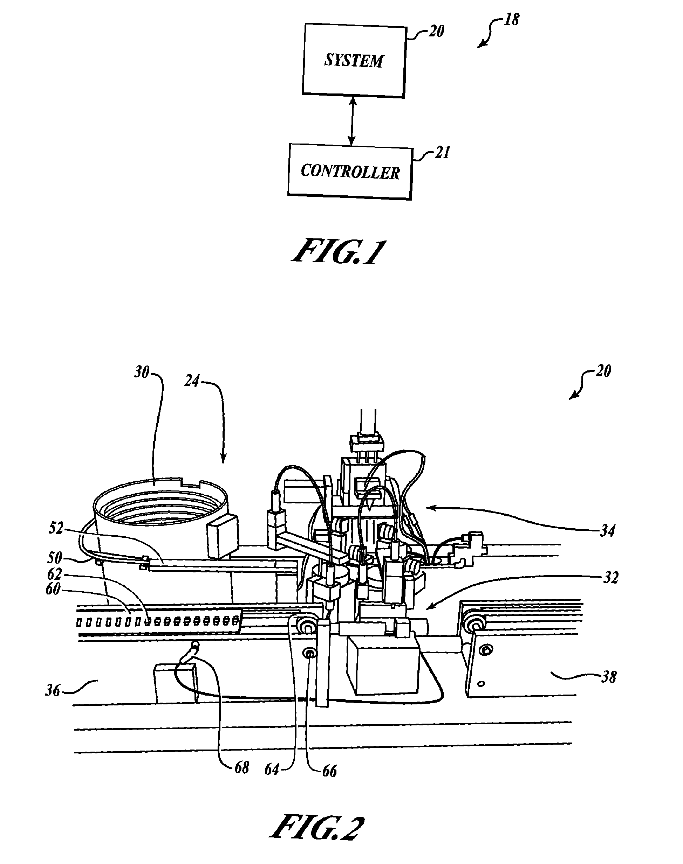

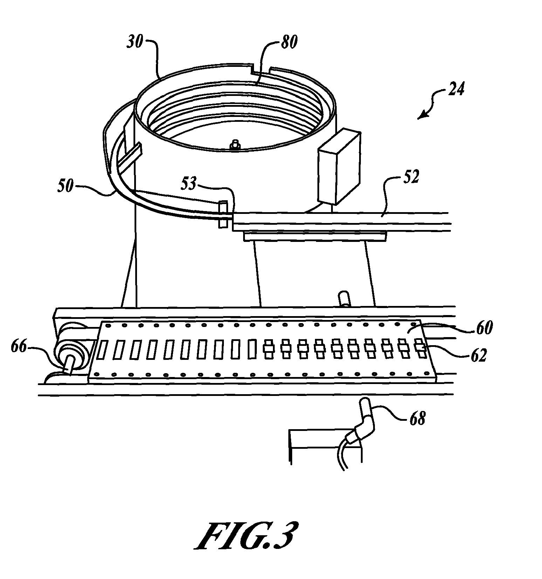

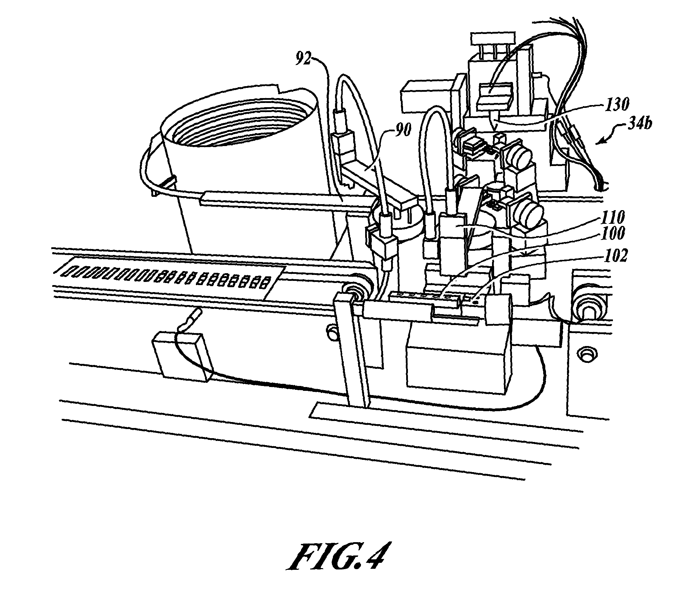

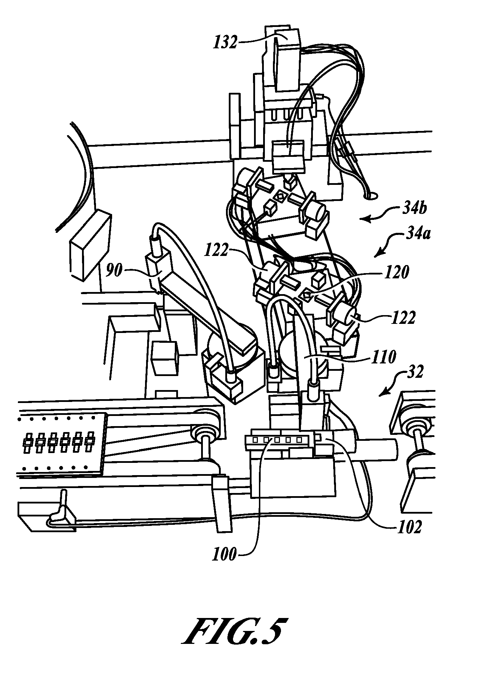

FIGURE 1 is a block diagram and FIGURES 2-5 are perspective views of an example system 18 for automatically attaching preforms to Leadless Chip Carriers (LCC's) in accordance with an embodiment of the present invention. An example preform is a stamped metal component (e.g., Gold-Tin). The system 18 includes a hydraulically and/or pneumatically driven parts retrieval and attaching system 20 that is controlled by a controller 21, such as a processor. The system 20 includes a preform loading section 24, an LCC loading area 32 and an attachment section 34. LCC's 62 are automatically retrieved from the loading area 32 and placed into the attachment section 34. Preforms are retrieved from the preform staging section 24 and loaded onto the LCC's into the attachment section 34. The retrieved preform is then tacked into place on the LCC 62 in the attachment section 34, then are returned to the loading area 32 for offloading.

The preform loading section 24 includes a loading bowl feeder 30 with attached off-loading ramps 50 and 52. The bowl feeder 30 includes a spiral ledge 80 that is attached to the interior wall of the bowl feeder 30. A mechanical vibrating device (not shown) vibrates the bowl causing preforms stored within the bowl to vibrate up the spiral ledge 80 until they reach an exit point in the bowl feeder 30. The ledge 80 is higher in Z direction on the side of the ledge 80 closer to the center to the bowl feeder 30. As the preforms reach the exit point of the bowl feeder 30 they travel down the first ramp 50. At the end of the ramp 50 or at the beginning of a straight ramp 52 the preforms are sensed by a sensor 53, such as an optical sensor. Once the sensor 53 senses that a preform has passed into the straight ramp 52, a signal is sent to the controller 21 which instructs the vibrating device to turn off. The straight ramp 52 includes a vibration mechanism (not shown) that causes preforms within the ramp 52 to travel to a preform nest 92. The ledge 80 is configured to filter out preforms that fail to meet design standards.

The LCC loading area 32 includes a first conveyer belt 36 that includes belts 64 that are driven by one or more motor driven shafts 66. The LCC's 62 rest in a conveyer boat 60. The boat 60 is placed on top of the belts 64 of the conveyor 36. The controller 21 controls operation of the conveyor 36 and instructs the conveyor 36 to move the boat 60 towards an LCC vacuum pick-up arm 110. The conveyor 36 includes a sensor 68, such as an optical sensor, that sends signals to the controller 21 based on the signal from the sensor 68 the controller 21 determines if an LCC 62 is located within the boat 60 as the boat 60 progresses along the conveyor 36. Once the boat 60 passes under the arm 110 the boat 60 stops at a stop gate 102. A plurality of position sensors are used throughout the system 20 to provide location information to the controller 21.

When the boat 60 is stopped underneath the arm 110 as sensed by a position sensor, a preheat rail 100 is mechanically moved up underneath the boat 60 to come into contact with five of the LCC's 62 (provided they are present) that are located on the boat 60. The preheat rail 100 heats up the LCC's 62 to a temperature greater than 180°C. After a predetermined period of time has elapsed, the arm 110 picks up one of the been preheated LCC's 62 using a suction force produced by a vacuum system (shown partially by hoses). The arm 110 moves the retrieved LLC to an LLC nest 120 located in a first subsection 34a of the attachment section 34. Then, a preform arm 90 retrieves the preform that is staged on the preform nest 92 and rotates it approximately 45° to the nest 120 and places the preform onto the LCC 62. The preform is not secured to the LCC 62 until a bonding step. In another embodiment, a clamping device 122 secures the preform to the LCC 62 prior to permanently being attached by a soldering/bonding step.

Once the preform has been extracted from the preform nest 92 a sensor (not shown), e.g. optical sensor, sends a signal to the controller 21 that determines that no preforms are present on the nest 92. The controller 21 then instructs the bowl vibrating device to vibrate the bowl until another preform passes through the sensor 53.

After the preform is placed on top of the LCC 62 in the nest 120 the nest 120 is rotated in position into a section 34b of the attachment section 34. In the section 34b a tacking device 132 applies a plurality of tacks using a heated tip 130 (e.g., solding tip) that is moved into place by an X, Y, Z motion control device. The tacking device 132 applies pressure between the tip 130 and the preform and the LCC 62 for a thermal compression bond. The tip 130 is heated to greater than 200°C. The nest 120 includes a heating element for heating the LLC to greater than 200°C, thereby keeping the LCC 62 near an optimal temperature for preform attachment. If other materials are used that melt/solder at lower temperatures, then the tip 130 and other components bring the LCC 62 to temps lower than 200°C.

After the preform is tacked to the LCC 62 at the section 34b, the nest 120 rotates back to the position identified in section 34a. The arm 110 is instructed by the controller 21 to retrieve the LCC 62 with the tacked preform from the nest 120 after the clamping device 122 has released pressure on the LCC 62. The arm 110 returns the preform tacked LCC back to the position on the boat 60 that is presently empty. The boat 60 then continues on to a second conveyer 38 and the process repeats itself.

The controller 21 controls the operation of the system 20 based on more than one program sequence. A program sequence that is selected is chosen or altered based on information received from the position sensors.

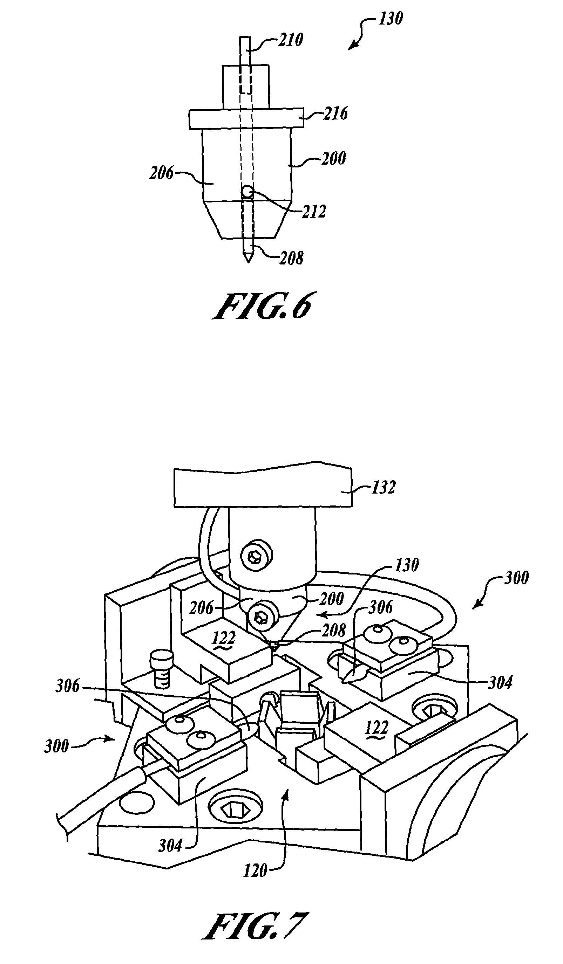

FIGURE 6 illustrates a cross-section view of an example tip 130. The tip 130 includes a base section 200 having a Copper core that is plated with Nickel 206. A Tungsten Carbide tip 208 is pressure fitted into a cavity within a first end of the Copper core/base section 200. The other end of the Copper core/base section 200 receives a heating element 210 that is connected to a heating circuit being controlled by the controller 21. A cavity 212 in the side of the base section 200 receives a thermo coupler/sensor that sends temperature signals to the controller 21. The base section 200 includes an annular ridge 216 that is received by opposing support mechanism (e.g., set screw) within the tacking device 132. When the base section 200 is properly placed within the tacking device 132, the heating element 210 is properly connected to circuit leads (not shown) with the tacking device 132.

FIGURE 7 illustrates the section 34b with the tacking device 132 and the tip 130 positioned above the LCC 26 and preform resting in the nest 120. The clamping device 122 holds the LCC 26 in place. An oxygen evacuation system 300 is positioned on an axis orthogonal to the axis of the two clamping devices 122. The oxygen evacuation system 300 includes gas feed tubes 306 that is connected to a gas supply device (not shown). The gas feed tubes 306 are directed toward the nest 120 by tube clamps 304 that are attached to outer surfaces of the nest 120. The gas feed tubes 306 supply a non-oxidizing gas, such as Nitrogen or Argon, onto the pieces that are to be attached in the nest 120.

All or parts of the system 20 may be included in a vacuum chamber or air content control chamber for reducing contamination of the process.

While the preferred embodiment of the invention has been illustrated and described, as noted above, many changes can be made without departing from the spirit and scope of the invention. For example, the standards for delivering and attaching the preforms complies with Surface Mount Equipment Manufacturers Association (SMEMA) technology. Also, a tape and reel feeder may be used in place of the bowl feeder. Accordingly, the scope of the invention is not limited by the disclosure of the preferred embodiment. Instead, the invention should be determined entirely by reference to the claims that follow.
The embodiments of the invention in which an exclusive property or privilege is claimed are defined as follows:

## Claims

1. A method for automatically attaching preforms to substrates, the method comprising:
a) placing a substrate into a nest;
b) placing a preform on the substrate in the nest;
c) tacking the preform to the substrate;
d) sensing operations of a)-c); and
e) automatically controlling a)-c) based on the sensed operations.

2. The method of Claim 1, wherein a) comprises automatically retrieving the substrate from a conveyor component, further comprises automatically returning the substrate with tacked preform to the conveyor component.

3. The method of Claim 2, further comprising heating the substrate before the substrate is retrieved from the conveyor component and heating the substrate in the nest.

4. The method of Claim 1, wherein b) comprises automatically retrieving preforms from a feeder, wherein the feeder includes at least one of a bowl feeder or a tape and reel feeder.

5. The method of Claim 1, wherein c) comprises tacking using a Tungsten Carbide tip partially housed within a Copper base plated with Nickel, further comprising evacuating oxygen proximate to the preform and substrate prior to tacking.

6. A system for automatically attaching preforms to substrates, the system comprising:
a nest;
a first component configured to place a substrate into the nest;
a second component configured to place a preform on the substrate in the nest;
a tacking device configured to tack the preform to the substrate;
a plurality of sensors for sensing operational states of the components and the tacking device; and
a controller configured to automatically control operations of the components and the tacking device based on the sensed operational states.

7. The system of Claim 6, wherein the first component comprises a conveyor component configured to transport one or more substrates and a mechanical arm configured retrieve one of the one or more substrates from the conveyor component and place the retrieved substrate in the nest, wherein the conveyor component comprises a heating device configured to heat one or more of the substrates prior to retrieval by the mechanical arm, wherein the mechanical arm is further configured to return the substrate with tacked preform to the conveyor component.

8. The system of Claim 6, wherein the nest includes a heating device configured to heat the nested substrate.

9. The system of Claim 6, wherein the second component includes a feeder.

10. The system of Claim 6, wherein the tacking device includes a Tungsten Carbide tip partially housed within a Copper base plated with Nickel, further comprising an evacuating component configured to evacuate oxygen proximate to the preform and substrate prior to tacking.
